Europäisches Patentamt

European Patent Office

Office européen des brevets

(11) Numéro de publication : **0 372 644 B1**

(12) **FASCICULE DE BREVET EUROPEEN**

(45) Date de publication du fascicule du brevet :
03.05.95 Bulletin 95/18

(51) Int. Cl.⁶ : **H01L 21/768**

(21) Numéro de dépôt : **89203064.4**

(22) Date de dépôt : **04.12.89**

(54) **Procédé de réalisation d'un circuit intégré incluant des étapes pour réaliser des interconnexions entre des motifs réalisés à des niveaux différents.**

(30) Priorité : **09.12.88 FR 8816230**
**19.09.89 FR 8912263**

(43) Date de publication de la demande :
**13.06.90 Bulletin 90/24**

(45) Mention de la délivrance du brevet :
**03.05.95 Bulletin 95/18**

(84) Etats contractants désignés :
**DE FR GB IT NL**

(56) Documents cités :
**EP-A- 0 100 166**
**DE-A- 3 443 793**
**US-A- 4 541 169**
**US-A- 4 541 169**
**3EME SYMPOSIUM INTERNATIONAL SUR LA GRAVURE SECHE ET LE DEPOT PLASMA ENMICROELECTRONIQUE, Cachar, 26-29 novembre 1985, pages 79-83; A. SCHILTZ et al.:"Procédés de planarisation par gravure grande vitesse"**

(56) Documents cités :
**IBM TECHNICAL DISCLOSURE BULLETIN, vol. 21, no. 3, août 1978, pages 1126-1127;D.A. SODERMAN: "Polysilicon gate fet process with substrate contacts"**

(73) Titulaire : **LABORATOIRES D'ELECTRONIQUE PHILIPS**
**3, Avenue Descartes**
**F-94450 Limeil-Brévannes (FR)**
(84) **FR**
Titulaire : **Philips Electronics N.V.**
**Groenewoudseweg 1**
**NL-5621 BA Eindhoven (NL)**
(84) **DE GB IT NL**

(72) Inventeur : **Villalon, Claudine**
**Société Civile S.P.I.D.**
**209 rue de l'Université**
**F-75007 Paris (FR)**

(74) Mandataire : **Landousy, Christian et al**
**Société Civile S.P.I.D.**
**156, Boulevard Haussmann**
**F-75008 Paris (FR)**

## Description

L'invention concerne un procédé de réalisation d'un circuit semiconducteur intégré comprenant, pour réaliser des interconnexions (VIAS) entre un premier niveau et un second niveau de conducteurs de ce circuit, les étapes successives de :

(a) formation, au premier niveau, sur un substrat S plan, de motifs conducteurs dits premier motifs présentant des premières parties $P_1$ et des secondes parties $P_2$ de hauteurs égales $H_m$, ayant au moins une de leurs dimensions, $W_1$ et $W_2$ respectivement, telle que la dimension $W_1$ dans les premières parties P1 est très inférieure à la dimension $W_2$ dans les secondes parties $P_2$, tel que $W1 \leqq W_2/2$ ;

(b) croissance d'une première couche $D_1$ en un matériau d'isolation électrique, qui s'étend de façon uniforme sur le substrat muni des motifs avec la même épaisseur sur les premières et secondes parties $P_1$ et $P_2$, et entre ces parties ;

(c) dépôt d'un seconde couche $D_2$ en un matériau diélectrique polymérisable, qui s'étend en présentant une épaisseur plus faible au-dessus des premières parties $P_1$ qu'au-dessus des secondes parties $P_2$, et polymérisation de cette couche.

L'invention trouve son application dans la réduction des surfaces des circuits intégrés montrant plusieurs niveaux d'interconnexions, et d'une façon générale dans la réalisation d'interconnexions entre des motifs disposés à des niveaux différents.

L'invention trouve une application toute particulière dans la réalisation de connexions entre des éléments de dimensions micronique et submicronique, dans des circuits planaires ou non planaires.

Un procédé tel que défini plus haut est déjà connu du brevet US-A-4 541 169. Ce procédé comprend des étapes pour réaliser des interconnexions entre deux niveaux de métallisation lors de l'élaboration d'un circuit intégré. A cet effet, ce procédé comprend, après la formation des fils du premier niveau de métallisation ayant des largeurs différentes, la réalisation de "piliers" qui sont des métallisations cylindriques debout sur ces fils, ayant une même hauteur, et une même élévation par rapport au plan de certains des fils, mais des surfaces différentes suivant la largeur des fils sous-jacents. La surface supérieure des piliers est donc circulaire, mais d'étendue différente selon les piliers. Ce procédé comprend ensuite la réalisation de deux couches diélectriques successives : une première couche en un matériau bon isolant d'oxyde de silicium, et une deuxième couche en une photorésist. La première couche est étendue de manière conforme, en montrant des reliefs au-dessus des piliers et des dénivellations entre les piliers ; et la seconde couche est planarisante, c'est-à-dire qu'elle montre une surface presque plane avec cependant une épaisseur légèrement plus faible au-dessus des piliers de faible surface qu'au dessus des piliers de grande surface. A ce stade du procédé, une gravure uniforme est réalisée pour graver ces deux couches diélectriques avec la même vitesse. Le résultat est que, lorsque la surface supérieure des piliers de petite étendue est juste découverte, à l'issue de la gravure, il reste encore sur les piliers de grande étendue, un "résidu" de couche de SiO2. Comme les piliers ont été conçus comme moyens d'interconnexions entre deux niveaux de métallisation du circuit intégré, tous ces piliers doivent être découverts. Donc des étapes ultérieures du procédé sont prévues pour atteindre ce but. A cet effet, une couche d'un second diélectrique bon isolant, du Si3N4 est réalisée, surmontée d'une nouvelle couche de photorésist. Puis le masque qui avait déjà servi pour la réalisation des piliers métalliques est utilisé, et des ouvertures sont pratiquées dans cette couche de photorésist. Ensuite la couche du second diélectrique Si3N4 est gravée à travers ces ouvertures, cette fois jusqu'à ce que la surface supérieure des piliers de petite et de grande étendue soit découverte. Par cette gravure, il apparaît une petite couronne sous-gravée autour des piliers de petite étendue. Le dispositif final montre tous les piliers découverts quelle que soit leur surface, grande ou petite, et est protégé entre les piliers par deux couches d'isolant SiO2 + Si3N4.

La publication intitulée "Procédé de planarisation par gravure à grande vitesse" 3ème Symposium International sur la gravure sèche et le dépôt plasma en microélectronique, 26-29 Nov.1985, pp.79-83, enseigne également l'action planarisante obtenue par la gravure uniforme, à vitesse égale, de la couche composite formée d'une couche de résine étendue sous forme fluide sur une couche de de SiO2. Alors que la couche de SiO2 montre des irrégularités, la couche supérieure de résine est pratiquement plane. Le résultat est que l'état de surface pratiquement plane est transféré au matériau SiO2 par cette gravure uniforme. Cette méthode est proposée pour éviter l'inconvénient qui apparaît si une couche de résine, par exemple une photorésist, est réalisée seule et que le dispositif sous-jacent présente des motifs structuraux ayant des tailles et périodicités variables. L'altitude du profil de la couche de résist est plus faible sur les petits motifs que sur les marches semi-infinies. Il en résulte donc un problème pour réaliser des ouvertures dans la résine, car les différents motifs ne sont pas gravés simultanément et l'homme du métier a des difficultés à choisir l'instant d'arrêt de gravure.

Il est connu du brevet US-A-4 621 045, un procédé de réalisation d'un circuit intégré qui inclut la réalisation sur un substrat de plots d'interconnexion conducteurs de grande surface, et de piliers conducteurs de faible surface. Ce procédé comprend la formation sur le dispositif ainsi constitué, d'une couche d'un matériau ayant à la fois des propriétés d'isolant électrique et de couche planarisante. Cette couche présente du fait de ses propriétés de couche planarisante, une épaisseur plus faible sur les piliers de faible surface que sur les plots de grande surface. Ce procédé comprend en outre la gravure uniforme de cette couche diélectrique planarisante avec un arrêt de la gravure dès l'apparition de la surface supérieure des piliers.

Du fait que le diélectrique déposé sur le dispositif comprenant les grands et les petits motifs est formé d'une seule couche, il faut que cette couche soit dotée d'au moins deux propriétés à la fois c'est-à-dire être un bon isolant électrique et être en même temps planarisante.

En effet, lorsque le procédé est terminé, il se trouve que la couche conductrice supérieure est seulement isolée de la couche conductrice inférieure par une couche de photoresist rendue insoluble par insolation, ou par une couche de polyimide, c'est-à-dire par une couche dont la propriété première et essentielle est d'être planarisante, cette couche étant choisie parmi les matériaux qui sont en outre isolants électriquement.

Or il se trouve que, pour la réalisation des circuits intégrés de la dernière génération ces propriétés ne sont pas suffisantes : la couche isolante qui sépare deux couches conductrices doit avoir en outre des propriétés de passivation du matériau semiconducteur qu'elle recouvre, des propriétés de résistance mécanique, de résistance en température pour subir des étapes ultérieurs de réalisation du circuit intégré, et de résistance au vieillissement.

Aucune de ces propriétés ne se trouvent à ce jour parmi les matériaux connus pour leur propriété planarisante : ils sont incapables d'assurer la passivation du matériau semiconducteur s'ils sont directement en contact avec ce dernier, ils ont une faible résistance mécanique, une faible résistance en température (tout au plus 250°C) et ils vieillissent mal.

Le fabricant de circuits intégrés refusera donc, de nos jours, de mettre en oeuvre tout circuit incluant une couche définitive de laque ou de résine. C'est pourquoi, le procédé connu du document cité devient caduque du fait qu'il résulte en un circuit qui n'est plus en synergie de fabrication avec les nouveaux circuits intégrés.

Il faut donc éviter de conserver une telle couche parmi les couches définitives.

Ensuite, il se pose un problème dans le cas où ces circuits sont en outre non planaires. Ainsi, l'état de la technique US-A-4 541 169 enseigne à réaliser une interconnexion avec un motif disposé dans une région plus profonde du circuit, ce qui arrive lorsque l'on veut réaliser des connexions avec des électrodes de différents transistors non planaires par exemple, en utilisant des piliers intermédiaires formés sur les fils de métallisations de la région profonde du premier niveau.

Un objet de l'invention est de fournir un procédé qui permet de réaliser des ouvertures, sans nécessiter de masques d'ouverture, sur tous les motifs d'un circuit choisis, et dans des régions d'interconnexion choisies, quelle que soit, à l'origine, la dimension du motif sur lequel on désire réaliser une ouverture, et quel que soit, à l'origine, le degré de planéité du substrat sur lequel il est réalisé.

Un autre objet de l'invention est de fournir un procédé qui permet de réaliser des ouvertures et donc des interconnexions directement avec des motifs microniques ou submicroniques.

Un autre objet de l'invention est de fournir un procédé pour réaliser un circuit intégré en synergie de fabrication avec les circuits intégrés de la dernière génération.

Un autre objet de l'invention est de fournir un procédé simple et d'un faible coût en regard de tous les avantages qu'il présente.

Un autre objet de l'invention est de fournir un procédé de réalisation résultant en un circuit intégré dépourvu de couches définitives non fiables et au contraire muni de couches isolantes ayant de bonnes performances électriques et mécaniques.

Un autre objet de l'invention est de fournir un procédé de réalisation résultant en un circuit où la (ou les) couche(s) isolante(s) sont aussi des couches de passivation.

Un autre objet de l'invention est de fournir un procédé applicable à la réalisation des circuits aussi bien planaires que non planaires.

Un autre objet de l'invention est de fournir un procédé qui résulte en la planarisation du dispositif, même si ce dernier était à l'origine non planaire.

Selon l'invention, ces buts sont atteints au moyen d'un procédé de réalisation d'un circuit intégré selon la revendication 1, tel que décrit dans le préambule et caractérisé en ce que dans l'étape b) l'épaisseur $H_d$ de la couche $D_1$ de matériau isolant au-dessus des premières et secondes parties de motifs $P_1$, $P_2$ est supérieure ou égale à la hauteur $H_m$ de ces parties $P_1$, $P_2$ de motifs, tel que $H_d \geqq H_m$, et en ce que ce procédé comprend ensuite les étapes successives de :

(d) gravure de la seconde couche $D_2$ de matériau de planarisation, sans masque, de manière uniforme, avec arrêt de cette gravure dès que la première couche $D_1$ sous-jacente est découverte dans les régions où l'épaisseur de la seconde couche $D_2$ était plus faible, formant des ouvertures dans cette seconde couche $D_2$ exclusivement au-dessus des premières parties $P_1$,

(e) gravure de la première couche $D_1$, à travers les ouvertures formées dans la seconde couche $D_2$, jusqu'à ce que les surfaces supérieures des premières parties $P_1$ soient découvertes, à l'exclusion des surfaces supérieures des secondes parties $P_2$, cette gravure étant pratiquée avec une vitesse d'attaque du matériau isolant de la première couche $D_1$ plus grande que la vitesse d'attaque du matériau de planarisation de la seconde couche $D_2$.

Un avantage est que l'on peut réaliser, sans masque, des ouvertures directement sur des motifs microniques ou submicroniques.

Un autre avantage est que la couche de planarisation $D_2$ en laque ou résine peut être éliminée.

Un autre avantage qui résulte immédiatement de ce procédé est que, du fait que la première couche diélectrique $D_1$ est déposée en épaisseur uniforme, on peut trouver parmi les matériaux qui se déposent d'une manière uniforme, des composés capables de constituer des bonnes couches de passivation.

Un autre avantage est que l'on peut trouver parmi les matériaux aptes à se déposer en couche uniforme $D_1$, des matériaux qui ont, outre la propriété de passivation, de meilleures performances de solidité mécanique et de meilleures performances en tant qu'isolant électrique que la couche isolante connue de l'état de la technique US-A-4621 045 (d'une manière générale que les couches qui se déposent sous forme fluide ou couches de planarisation).

Un autre avantage, dû au fait que la première couche diélectrique $D_1$ est déposée en épaisseur uniforme, est que l'on peut trouver parmi les matériaux capables de se déposer en épaisseur uniforme, des matériaux qui ont non seulement les avantages cités précédemment, mais encore, qui sont en synergie de fabrication avec toutes les technologies actuelles de circuits intégrés et avec celles qui ont déjà été sélectionnées pour être mises en oeuvre dans un proche avenir.

Dans une mise en oeuvre, ce procédé est caractérisé en ce que l'étape a), des motifs conducteurs susceptibles d'être connectés avec des conducteurs du niveau supérieur du circuit sont munis de parties $P'_1$, éventuellement sous forme de rétrécissements ou d'appendices, ayant au moins une dimension $W_1$ et une hauteur $H_m$, répondant aux conditions imposées aux premières parties $P_1$.

Un avantage est que l'on peut ouvrir des ouvertures sur les parties de grandes dimensions sans étapes supplémentaires, c'est-à-dire au cours de la même étape que l'étape d'ouverture sur les parties $P_1$ ayant au moins une faible dimension $W_1$, et de plus sans mettre en oeuvre d'autre masque que celui qui est nécessaire pour définir les motifs conducteurs dans la première étape a) du procédé.

Un autre avantage est que les ouvertures tant sur les premières parties $P_1$ que sur les parties $P'_1$ occupent une surface du circuit extrêmement restreinte.

Un autre avantage est que l'on peut choisir comme régions d'interconnexion pour les parties $P'_1$, des régions qui peuvent être éloignées des grands motifs ou situées dans des zones qui, sans le procédé, auraient été perdues, ce qui offre des possibilités nouvelles d'arrangement du dessin des circuits, profitables au concepteur de circuits intégrés.

Dans une mise en oeuvre, ce procédé est caractérisé en ce que dans l'étape a) des motifs conducteurs $P_3$ ayant une élévation inférieure à celles des premières parties $P_1$, et susceptibles d'être connectés à des conducteurs du niveau supérieur du circuit, sont munis de lignes conductrices $L_1$ présentant respectivement, d'une part des zones de contact avec ces troisièmes parties $P_3$, et d'autre part, des parties $P''_1$, éventuellement sous forme de rétrécissements ou appendices, ayant au moins une dimension $W_1$ et une élévation répondant aux conditions imposées aux première parties $P_1$.

Un avantage est que le procédé est applicable aussi bien aux circuits planaires qu'aux circuits non planaires.

Un autre avantage est qu'il est beaucoup plus facile de réaliser, pour élever le niveau des parties $P_3$, des lignes, plutôt que des piliers comme enseigné par l'état de la technique. En effet, dans la création des lignes conductrices $L_1$, le procédé de masquage n'est pas critique.

Un autre avantage est que l'on peut choisir la région d'interconnexion dans des zones favorables du circuit, comme il a été dit pour le choix des régions d'interconnexion relatives à la formation artificielle de parties rétrécies $P''_1$.

Un autre avantage est que l'on peut ramener toutes les régions d'interconnexions du circuit sur un même niveau, quel que soit le niveau d'origine des parties $P_3$, et réaliser les ouvertures en une seule étape et sans masque, pourvu que les parties $P_1$, $P'_1$, $P''_1$ aient au moins une, ou seulement une dimension de plus petite valeur que les autres dimensions des motifs conducteurs à ce niveau.

Dans une mise en oeuvre, ce procédé est caractérisé en ce que l'épaisseur $H_d$ de la première couche diélectrique $D_1$ est choisie, en fonction de la hauteur $H_m$ des premières parties $P_1$ et de la différence $H_\ell$ entre l'épaisseur de la couche $D_2$ au-dessus des deuxièmes parties P2 et l'épaisseur de la couche $D_2$ au-dessus des premières parties $P_1$ pour répondre à la condition :

$$H_d = H_m^2(H_m - H_\ell)^{-1}$$

et en ce que le rapport S de la vitesse de gravure de la première couche diélectrique $D_1$ sur la vitesse de gravure de la seconde couche diélectrique $D_2$, dans la seconde étape de gravure e), est choisi pour répondre à la condition :

$$S = (H_d - H_m)H_\ell^{-1} > 1$$

Un avantage est qu'à l'issue du procédé, le dispositif peut être planaire alors même que le matériau formant la couche diélectrique $D_1$ restante ne fait pas partie des matériaux dits de planarisation.

Un autre avantage est que, dans le cas des circuits à l'origine non planaires, le procédé offre la possibilité d'obtenir à l'issue de la dernière étape, un dispositif néanmoins planaire;

Dans une mise en oeuvre, ce procédé est caractérisé en ce que les premières parties $P_1$ sont des motifs microniques ou submicroniques, par exemple des grilles de transistors à effet de champ ou des émetteurs de transistors bipolaires, en ce que les secondes parties $P_2$ sont des électrodes de composants actifs ou des lignes d'interconnexions, et en ce que les troisièmes parties $P_3$ sont des électrodes de composants actifs non planaires, par exemple des bases ou des collecteurs de transistors bipolaires.

L'invention permet donc la miniaturisation des circuits non planaires, et planaires, la simplification de leur fabrication, l'amélioration de leurs qualités, et la diminution de leurs coûts de fabrication.

L'invention sera mieux comprise au moyen de la description suivante illustrée par les figures annexées dont :

- les figures 1a à 1d qui illustrent les premières étapes du procédé selon l'invention, dans le cas où les premiers motifs comprennent des parties $P_1$ et $P_2$ coplanaires ;
- les figures 2a et 2b qui illustrent les étapes suivantes du procédé dans une première variante et dans le cas où les premiers motifs comprennent des parties $P_1$ et $P_2$ coplanaires ;
- les figures 3a et 3b qui illustrent les étapes suivantes du procédé dans une seconde variante et dans le cas où les premiers motifs comprennent des parties $P_1$ et $P_2$ coplanaires ;
- les figures 4a et 4b qui montrent les hauteurs de couches mises en oeuvre dans les étapes menant à la seconde variante de l'invention ;
- la figure 4c qui est une vue du dessus de la figure 4b et qui montre que la surface entière des parties $P_1$ peut être découverte à ce stade du procédé ;
- la figure 5a qui représente vu du dessus une interconnexion entre une première partie $P_1$ disposée sur un premier niveau du circuit et une troisième partie $P_3$ disposée sur un second niveau du circuit inférieur au premier, obtenue au moyen du procédé selon l'invention ;
- les figures 5b et 5c qui représentent en coupe une telle interconnexion, la figure 5c étant une coupe selon l'axe I-I de la figure 5a.
- les figures 6a et 6b qui montrent vu du dessus des exemples d'interconnexions entre diverses parties de circuits intégrés, réalisées au moyen du procédé selon l'invention.

Le procédé selon l'invention s'applique tout particulièrement à la réalisation d'interconnexions entre des motifs métalliques ($P_1$, $P'_1$, $P''_1$) disposés à undit premier niveau $N_1$ du circuit au moyen des lignes d'interconnexion ou des seconds motifs $L_2$ réalisés dans une couche métallique séparée des premiers motifs du premier niveau $N_1$ par une couche diélectrique $D_1$.

La présente invention propose un procédé permettant d'ouvrir des ouvertures ou VIAS dans la couche diélectrique $D_1$ uniquement sur les parties $P_1$, $P'_1$, $P''_1$ des motifs qui présentent au moins une de leur dimension $W_1$ parallèlement au premier niveau $N_1$, de valeur faible par rapport à celles $W_2$ des autres parties $P_2$ de ces motifs, ces autres parties restant couvertes par la couche diélectrique $D_1$, et cela sans utiliser de masques conventionnels difficiles à réaliser, à positionner et donc coûteux dans la mise en oeuvre d'un procédé.

Dans un exemple de mise en oeuvre, le procédé selon l'invention comporte d'abord les étapes successives suivantes :

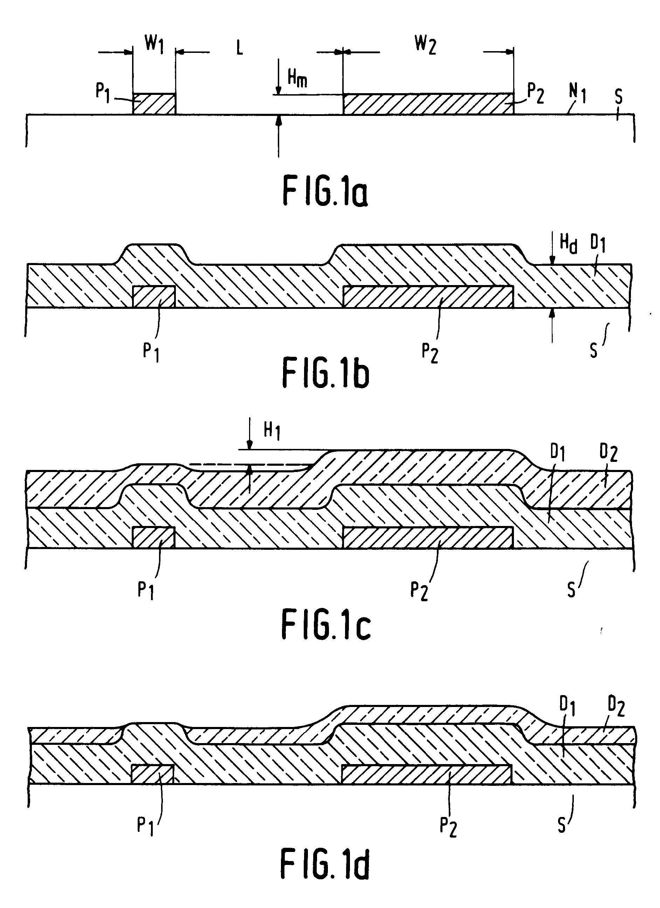

A) réalisation, tel que représenté en coupe sur la figure 1a, sur un niveau $N_1$ du circuit intégré, de motifs métalliques ou semiconducteurs ayant des parties $P_1$ et $P_2$.

Le premier niveau $N_1$ peut être la surface supérieure d'un substrat S en un matériau semiconducteur tel que le silicium ou l'arséniure de gallium.

Le premier niveau peut aussi être déjà un second niveau d'interconnexion. D'autre part, les premières parties $P_1$ peuvent être en un matériau semiconducteur, par exemple un émetteur d'un transistor bipolaire.

Les parties $P_1$ présentent une hauteur $H_m$. On étudie ici uniquement le cas où les parties $P_1$ présentent une hauteur $H_m$ supérieure ou sensiblement égale à la hauteur des parties $P_2$.

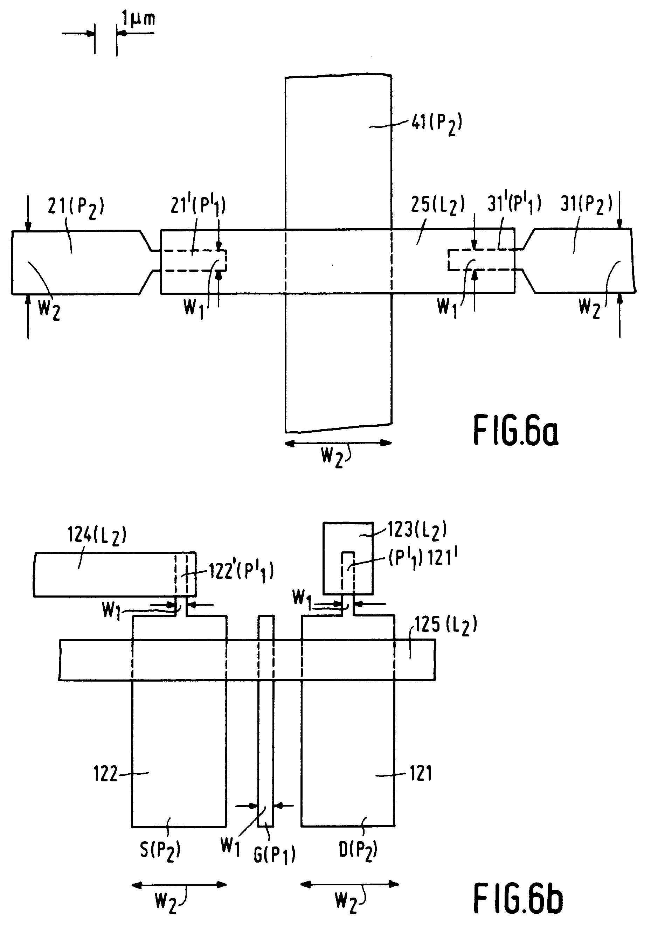

Les parties $P_1$ sont en outre définies par une dimension latérale $W_1$ et les parties $P_2$ par une dimension latérale $W_2$. Le but de l'invention est de réaliser des ouvertures ou VIAS sur les parties $P_1$ dans le cas où elles présentent au moins une dimension $W_1$ inférieure ou environ égale à la moitié de la dimension $W_2$ des parties $P_2$. Dans l'exemple de réalisation de la figure 1a, les premières parties $P_1$ sont séparées des secondes parties $P_2$ par une distance L. Mais cela est un cas particulier. Les parties $P_1$ et $P_2$ peuvent être accolées comme le montrent les figures 6a et 6b.

Les matériaux utilisés pour réaliser les motifs conducteurs ayant des parties $P_1$ et $P_2$ peuvent être tout métaux habituellement utilisés dans la réalisation de circuits intégrés tels que : AuGe, NiCr, TiPtAu, ou $W_n$, s'il s'agit de la grille d'un transistor (à effet de champ, bipolaire) ; ces matériaux peuvent être aussi l'aluminium ou le polysilicium s'il s'agit de lignes d'interconnexion ; ces matériaux peuvent être également tout semiconducteur.

Les hauteurs $H_m$ peuvent être dans la fourchette de quelques centaines de nanomètres à plusieurs microns.

Si, à ce premier niveau $N_1$, se trouvent comme montré sur la figure 6a des éléments tels que des lignes d'interconnexion 21 ou 31 qui par leurs dimensions ne se trouvent pas dans la catégorie des parties $P_1$, dites premières parties, parce qu'il existe déjà de telles parties plus petites qu'elles non représentées, sur lesquelles des VIAS sont prévus, il suffira alors de prévoir sur ces lignes où dans une partie de ces éléments, un rétrécissement ou un appendice $P'_1$, 21', 31' respectivement de dimensions appropriées $W_1$ de manière à faire entrer la région du rétrécissement ou de l'appendice $P'_1$ dans la catégorie desdites premières parties $P_1$. Dans les étapes ultérieures du procédé, la région du rétrécissement ou de l'appendice sera automatiquement la région de localisation du VIA souhaité.

On peut pratiquer ainsi facilement un rétrécissement ou un appendice $P'_1$ sur des lignes d'interconnexion (voir la figure 6a) mais aussi un appendice $P'_1$ à l'extrémité d'une électrode 121 ou 122 d'un transistor par exemple. Ainsi la figure 6b montre les appendices $P'_1$ respectivement 121' et 122' aux extrémités des électrodes de source S et drain D d'un transistor à effet de champ dont la grille G constitue une partie $P_1$.

C'est pourquoi selon l'invention, au lieu de prévoir des élargissements pour faire des VIAS, on prévoira le plus souvent des rétrécissements, dans des régions référencées $R_1$ ou régions d'interconnexion pour les parties $P_2$. Cela représente pour le concepteur de circuits intégrés, une toute nouvelle manière de travailler.

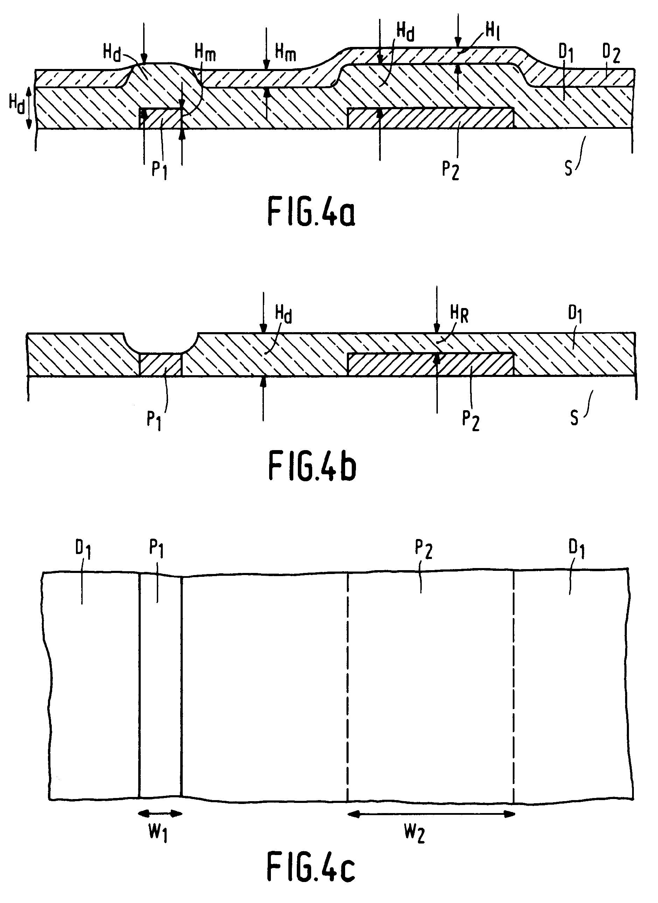

On notera que l'ouverture se fera sur la totalité de la région classée $P_1$, par exemple toute la surface supérieure de la grille G d'un transistor à effet de champ (voir figure 6b), ou toute la surface supérieure du tronçon de ligne rétrécie 21', 31', 121', 131', (voir les figures 6a, 6b ainsi que la figure 4c). Donc toute la partie $P_1$ est une région possible d'interconnexion référencée $R_1$.

Il en résulte un des avantages de l'invention, qui consiste en une grande économie de surface, notamment dans les première couches du circuit intégré qui sont aussi généralement les plus denses et qui déterminent la taille finale du substrat à utiliser et des facilités nouvelles pour le concepteur de circuits intégrés dans la prévision de l'emplacement des seconds motifs $L_2$.

B) Dépôt comme illustré par la figure 1b, d'une couche uniforme d'une première sorte de diélectrique $D_1$. Pour obtenir cette couche uniforme, le diélectrique $D_1$ doit être choisi parmi les matériaux que l'on dépose par une méthode de croissance, par exemple par une action chimique en phase vapeur connue sous le nom de CVD ou PECVD, ou par pulvérisation cathodique. Par couches uniformes il faut entendre que l'épaisseur $H_d$ du diélectrique $D_1$ est la même sur lesdites premières parties $P_1$, sur lesdites secondes parties $P_2$, et entre les parties $P_1$ et $P_2$. D'autre part, on choisira l'épaisseur de cette couche diélectrique $D_1$

$$H_d \cong H_m$$

$H_m$ étant la hauteur des premières parties $P_1$, par rapport au niveau $N_1$, dans le but qui est essentiel, de couvrir entièrement tous les motifs de ce premier niveau $N_1$ plan.

Cependant l'épaisseur du diélectrique $D_1$ dans cette étape dépend du but que l'on cherche à atteindre ultérieurement.

En effet, on peut mettre en oeuvre le procédé selon deux variantes.

La première de ces variantes est décrite à titre d'exemple non revendiqué. Elle permet d'obtenir une planarisation locale autour des premières parties $P_1$, les secondes parties $P_2$ restant néanmoins couvertes par la couche diélectrique $D_1$ formant un MESA sur ces parties $P_2$.

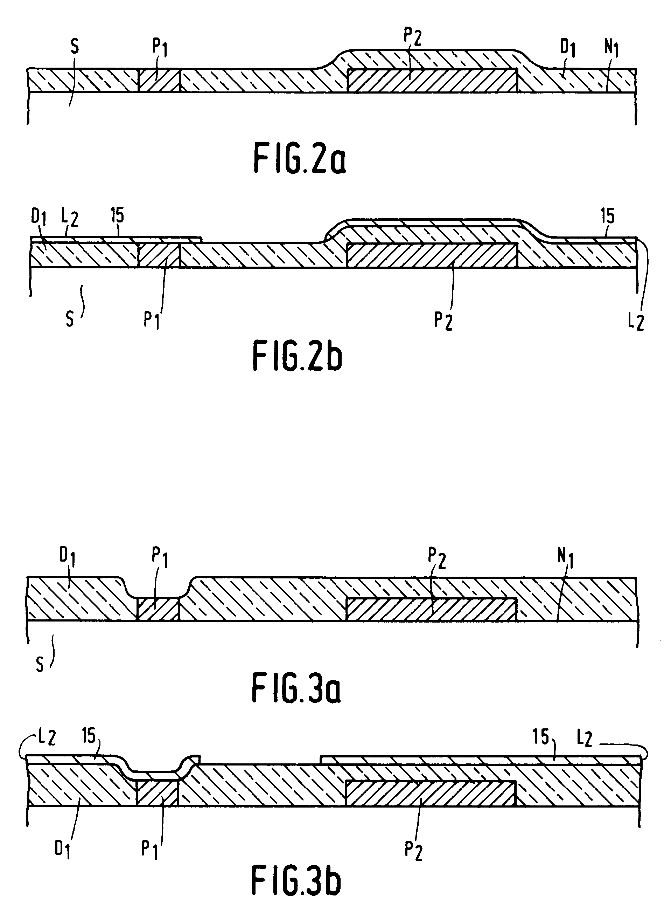

La seconde de ces variantes qui est décrite en référence avec les FIG.3A, 3B et FIG.4A, 4B est une mise en oeuvre de la présente invention. Elle permet d'obtenir une planarisation générale du dispositif, les secondes parties $P_2$ étant couvertes par le diélectrique $D_1$ et des fenêtres étant ouvertes au-dessus des premières parties $P_1$. Ces fenêtres ont une forme de cuvette de faible profondeur dont le fond est formé par la surface de ces premières parties $P_1$ comme il est montré sur la figure 3a. Si la mise en oeuvre selon l'invention est choisie, il faudra déposer lors de cette étape de réalisation de la couche diélectrique $D_1$ une épaisseur

$$H_d = H_m^2 (H_m - H_\ell)^{-1}$$

de ce matériau.

Dans cette relation, $H_\ell$ est la différence d'épaisseur qui s'établira au cours de l'étape suivante C) entre la première épaisseur d'une seconde couche de diélectrique $D_2$ au-dessus des premières parties $P_1$ et la seconde épaisseur de ladite seconde couche $D_2$ au-dessus des secondes parties $P_2$, pour mettre en oeuvre la seconde variante de l'invention.

La valeur de $H_\ell$ peut être trouvée soit par l'expérimentation, soit par la modélisation, et est de la forme :

$$H_\ell = k.H_m^2 (W_2 - W_1) (W_1 + H_m)^{-1} (W_2 + H_m)^{-1}$$

Des matériaux particulièrement favorables pour obtenir la couche $D_1$ peuvent être choisis parmi la silice ($SiO_2$) ou le nitrure de silicium ($Si_3N_4$), qui sont des isolants très fréquemment utilisés en technologie de circuits intégrés. Comme la couche $D_1$ est une couche définitive, il est impératif que ce diélectrique présente une qualité reconnue.

C) Réalisation d'une seconde couche diélectrique $D_2$ comme montré sur la figure 1c. Cette couche diélectrique $D_2$ doit être choisie parmi les matériaux qui s'étendent sous forme fluide permettant d'obtenir une première épaisseur sur les premières parties $P_1$ et une seconde épaisseur sur les secondes parties $P_2$. Notamment la seconde épaisseur sur les secondes parties sera supérieure à la première épaisseur sur les premières parties $P_1$ ;

La différence entre ces épaisseurs sera $H_\ell$ dont la formule a été donnée précédemment. On aura unedite troisième épaisseur, supérieure aussi à la première, entre les motifs s'ils sont séparés. Dans cette formule, k est une constante qui dépend du matériau choisi pour réaliser cette seconde couche diélectrique $D_2$. Pour réaliser la seconde couche diélectrique $D_2$, s'étendant de façon fluide, on pourra choisir des résines polymérisables telles qu'une résine époxy ou encore une laque photosensible dont on n'utilisera pas ici les propriétés connues pour la photolithographie, mais seulement le fait que les laques photosensibles se déposent en plus faible épaisseur sur des petits motifs que sur des grands motifs, quand elles sont déposées dans certaines conditions.

En considérant la répartition des épaisseurs d'une telle couche $D_2$ en fonction des dimensions W de différents motifs, on constate que les épaisseurs croissent au fur et à mesure que les dimensions W des motifs augmentent, lorsque la couche $D_2$ est déposée dans des conditions précisées plus loin. C'est pourquoi pour parvenir au but de l'invention et distinguer nettement les épaisseurs de diélectrique $D_2$ réalisées sur les différentes parties des motifs, il faut que ces parties présentent des dimensions nettement différentes. Ces différences de dimensions seront suffisantes lorsque $W_2$ sera supérieur ou environ égal à 2 fois $W_1$.

Cette distinction pourra se faire facilement dans les circuits intégrés du fait qu'il existe de par le dessin original des éléments ou parties de motifs de tailles très différentes,ou du fait que l'on peut toujours prévoir un rétrécissement ou un appendice $P'_1$ à l'emplacement ou l'on veut ouvrir un VIA.

On pourra choisir par exemple pour réaliser la couche diélectrique $D_2$ une laque photosensible positive AZ4110 (Sté SHIPLEY) déposée à l'aide d'une tournette dans les conditions suivantes :

- Vitesse de rotation 4500 tours/mn pendant une durée de 40 secondes ;
- Séchage de la laque à une température de 90°C pendant 30 minutes ;
- Exposition au rayonnement ultraviolet de longueur d'onde 300 nm avec une énergie de 900 mJ/cm² ;
- Recuits successifs à 90°C, 120°C, 180°C.

Dans le cas où cette laque photosensible est utilisée sur une couche de silice $SiO_2$, le coefficient k dans la formule donnant $H_\ell$ est de l'ordre de 1/2.

On ne recherchera pas la planarisation totale du dispositif au moyen de cette couche $D_2$, ce qui pourrait aussi être obtenu dans d'autres conditions de dépôt.

D) Mise en oeuvre d'une première étape de gravure sèche par exemple de gravure ionique réactive pour graver la seconde couche diélectrique $D_2$ avec une vitesse uniforme. Cette première étape de gravure sèche sera arrêtée dès que, en surface du dispositif, des plages de la première couche diélectrique $D_1$ apparaîtront. Des méthodes sont connues de l'homme du métier pour obtenir l'arrêt automatique de la gravure.

Si la laque photosensible positive citée précédemment a été utilisée, on obtiendra une gravure uniforme de cette laque au moyen de gaz $O_2$ en mélange avec le gaz vecteur $N_2$, avec une vitesse de gravure de l'ordre de 145 nm/mn. On cherchera à parvenir à une uniformité de l'ordre de ± 1 %.

Au-delà de cette étape, les conditions de gravure seront différentes selon que l'on veut parvenir à la variante du procédé non revendiquée, ou bien à la mise en oeuvre de l'invention. A l'issue de l'étape D) le dispositif tel que représenté sur la figure 1d en coupe, ou 4a en coupe, montre la couche du diélectrique $D_1$ encore non attaquée, recouverte par une épaisseur $H_\ell$ de la couche du diélectrique $D_2$ au-dessus des parties $P_2$. Au-dessus des premières parties $P_1$, cette épaisseur est nulle, la couche du premier diélectrique $D_1$ affleurant alors la surface.

C'est à partir de ce dispositif que peut être commencée une deuxième étape de gravure sèche ou gravure ionique réactive, cette seconde étape pouvant être menée de deux manières différentes, conduisant aux deux variantes citées plus haut.

La variante non revendiquée est obtenue à la suite de l'étape $E_1$ et la mise en oeuvre selon l'invention est obtenue à la suite de l'étape $E_2$ décrites ci-après. Le choix entre la variante et la mise en oeuvre de l'invention se fait en fonction des épaisseurs résiduelles $H_R$ de diélectrique $D_1$ que le concepteur de circuits intégrés veut conserver en surface des secondes parties $P_2$ de grandes dimensions. En effet, de l'épaisseur $H_R$ du diélectrique $D_1$ résiduel conservée en surface des parties $P_2$, dépendent par exemple les capacités parasites qui peuvent s'introduire dans le circuit entre les parties $P_2$ du premier niveau $N_1$ et des motifs métalliques situés à un niveau supérieur, c'est-à-dire en surface du diélectrique $D_1$ à la fin du procédé selon l'invention (voir les figures 3b et 3b).

Dans la suite du procédé menant à la variante non revendiquée, on trouve donc l'étape :

$E_1$/ mise en oeuvre d'unedite seconde étape de gravure sèche par exemple de gravure ionique réactive, avec une vitesse de gravure de la seconde couche $D_2$ égale à la vitesse de gravure de la première couche $D_1$. Cette gravure est arrêtée dès l'apparition de la surface supérieure des premières parties $P_1$. Une couche du premier diélectrique $D_1$ reste en surface des secondes parties $P_2$, formant un MESA, et ceci aussi bien dans le cas où les premières parties $P_1$ ont la même hauteur $H_m$ que les secondes parties $P_2$, que dans le cas où la hauteur $H_m$ des premières parties $P_1$ est supérieure à celle des secondes parties $P_2$. Les ouvertures formées en surface des premières parties $P_1$ sont alors parfaitement appropriées à constituer des VIAS. La couche $D_2$ a été complètement éliminée. Comme il a été dit précédemment, l'homme du métier emploiera, pour procéder à l'arrêt automatique de gravure une des méthodes connues de l'état de l'art.

La sélectivité de gravure S définie comme le rapport de la vitesse de gravure de la couche $D_1$ sur la vitesse de gravure de la couche $D_2$ doit donc être égale à 1.

Pour obtenir cette sélectivité S = 1, dans le cas exemple, où la couche du second diélectrique $D_2$ est la laque photosensible citée précédemment et où la couche du premier diélectrique $D_1$ est la silice $SiO_2$, le procédé selon l'invention peut être mené à bien à l'aide des gaz :

$SF_6$ avec un débit de 2,14 SCCM

$CHF_3$ avec un débit de 14,3 SCCM

$N_2$ avec un débit de 19,3 SCCM

les vitesses obtenues par ce système sont de l'ordre de 30,5 nm/mn pour le premier diélectrique $D_1$ et de 31 nm/mn pour le second diélectrique $D_2$.

Pour des premières parties $P_1$ dont la hauteur est :

$H_m \simeq 0,5\ \mu m$,

et la plus petite dimension latérale, c'est-à-dire mesurée parallèlement au plan du premier niveau $N_1$ est :

$W_1 \simeq 0,8\ \mu m$,

et pour des parties $P_2$ de même hauteur et de dimensions latérales mesurées dans le même plan :

$W_2 \simeq 5\ \mu m$,

ces motifs étant éventuellement espacés d'une distance :

$L \simeq 5\ \mu m$,

l'épaisseur de diélectrique $D_1$ résiduelle est égale à la différence $H_\ell$ du diélectrique $D_2$ qui existait à l'origine entre les parties $P_2$ et $P_1$ :

$H_R \simeq H_\ell \simeq 0,25\ \mu m$.

La mise en oeuvre du procédé selon l'invention est obtenue à la suite de l'étape suivante :

$E_2$/ En référence avec la FIG.4B, la mise en oeuvre selon l'invention implique après la gravure et arrêt de gravure de l'étape D), une seconde étape de gravure sèche, par exemple de gravure ionique réactive, avec une vitesse de gravure du premier diélectrique $D_1$ supérieure à la vitesse de gravure du second diélectrique $D_2$. Dans ces conditions, le premier diélectrique $D_1$ est attaqué dans les ouvertures pratiquées dans le second diélectrique $D_2$ au-dessus de premières parties $P_1$. Du fait que le premier diélectrique $D_1$ est gravé à une vitesse plus grande que le second diélectrique $D_2$, il en résulte des cuvettes formées au-dessus des parties $P_1$, montrant des flancs dont la cavité est tournée vers l'extérieur du dispositif et une faible profondeur. La gravure est arrêtée dès que la surface supérieure des premières parties $P_1$ apparaît dans ces cuvettes, en mettant en oeuvre une méthode d'arrêt de gravure connue.

L'avantage de cette mise en oeuvre selon l'invention est que, en choisissant bien la sélectivité S de gravure des couches diélectriques $D_1$ et $D_2$, on peut obtenir un dispositif complètement planaire, présentant seulement des ouvertures en forme de cuvettes en surface des parties $P_1$, ces ouvertures étant parfaitement appropriées à former des VIAS.

Si les dimensions et matériaux de l'exemple de réalisation décrit précédemment sont conservés, c'est-à-dire :

$H_m \simeq 0.5\ \mu m$,

$W_1 \simeq 0,8\ \mu m$,

$W_2 \simeq 5\ \mu m$,

$L \simeq 5\ \mu m$, éventuellement,

$H_\ell \simeq 0,25\ \mu m$,

alors pour obtenir la planarisation du dispositif dans les conditions illustrées par les figures 3a et 4b, l'épaisseur de diélectrique $D_1$ déposée doit être :

$$H_d \simeq H_m^2\ (H_m - H_\ell)^{-1}$$

et la sélectivité :

$$S \simeq (H_d - H_m)\ H_\ell^{-1}.$$

En choisissant

$H_d \simeq 1\ \mu m$,

cela revient, pour obtenir un dispositif planaire à trouver des conditions de gravure conduisant à

$S = 2$.

Pour des couches diélectriques $D_1$ et $D_2$ constituées respectivement de silice ($SiO_2$) et de laque photosensible positive citées précédemment, ces conditions de gravure sont obtenues, en gravure ionique réactive, au moyen des gaz :

$SF_6$ avec un débit de 1,9 SCCM

$CHF_3$ avec un débit de 24,5 SCCM

$N_2$ avec un débit de 9,3 SCCM,

à pression et puissance élevées.

Les vitesses de gravure sont alors de l'ordre de 23,5 nm/mn dans le second diélectrique $D_2$ (laque photosensible positive) et de 45,0 nm/mn dans le premier diélectrique $D_1$ ($SiO_2$).

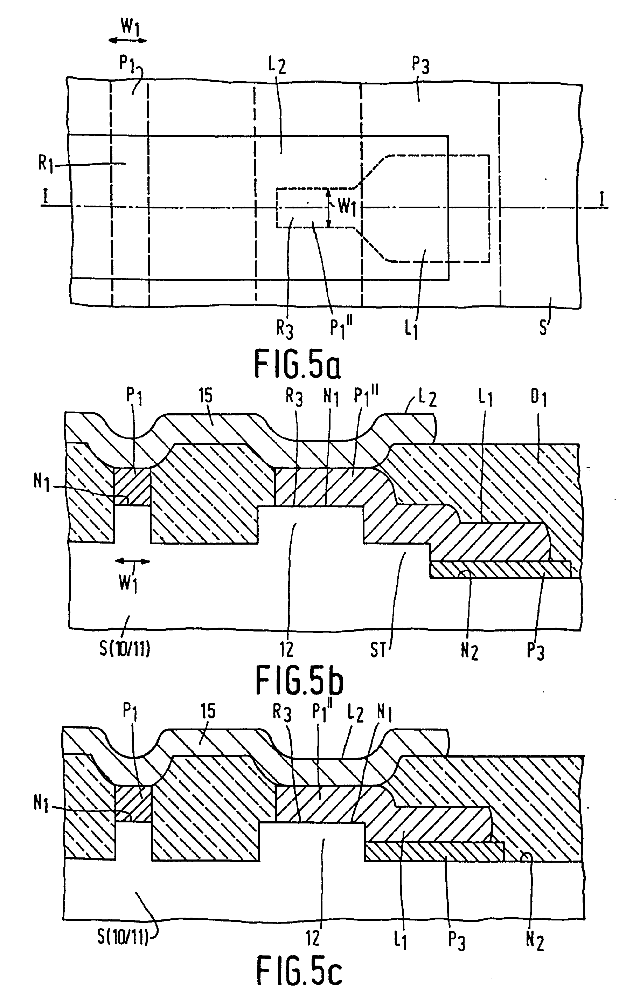

L'épaisseur résiduelle $H_R$ de premier diélectrique $D_1$ sur les secondes parties $P_2$ est dans ce cas de l'ordre de 0,45 $\mu m$ (voir la figure 5b).

Cette étape $E_1$ ou $E_2$ du procédé de réalisation peut aussi être mise en oeuvre si le premier diélectrique $D_1$ est différent, par exemple du nitrure de silicium $Si_3N_4$. Dans le cas de l'étape $E_2$ selon l'invention on choisira une sélectivité S plus grande que pour la silice $SiO_2$, par exemple S = 3 ou 4.

Comme on le constate à partir des figures 4a et 4b montrant les épaisseurs en jeu au cours des étapes D) et $E_2$) dans le cas où S = 2, à l'issue de l'étape $E_2$) l'épaisseur de diélectrique $D_2$ résiduel au-dessus des seconde parties $D_2$ ne dépend que de l'épaisseur initiale $H_m$ des premières parties $P_1$ et de celle $H_d$ du diélectrique $D_1$ :

$H_R \geqq H_d - H_m$.

D'autre part, il ne reste pas de second diélectrique $D_2$ à l'issue du procédé.

Il faut encore noter que les gaz utilisés pour la seconde étape de gravure sèche doivent graver sélectivement la première couche diélectrique $D_1$ de manière à permettre un arrêt facile du procédé dès qu'apparaît la surface supérieure des premières par-

ties $P_1$.

Pour obtenir l'interconnexion entre les premières parties $P_1$ du premier niveau $N_1$ et des motifs $L_2$ situés à un niveau supérieur du circuit, on peut ensuite procéder à la mise en oeuvre d'une étape :

F) Réalisation d'un masque de second niveau d'interconnexion et dépôt d'une couche métallique 15 dans les ouvertures de ce masque (voir les figures 2b et 3b). La mise en oeuvre de ce dépôt peut se faire par exemple par évaporation, par pulvérisation cathodique ou par croissance électrolytique avec des métaux choisis parmi les métaux aptes à former les premiers motifs du premier niveau et avec des épaisseurs pouvant varier de quelques dizaines de nanomètres à quelques microns. Les motifs $L_2$ de cette couche métallique 15 de niveau supérieur sont disposés de manière à présenter des régions situées en surface des VIAS ouverts lors des étapes $E_1$/ ou $E_2$/, établissant ainsi le contact électrique entre le niveau $N_1$ et le niveau supérieur isolés par ailleurs par l'épaisseur résiduelle de la couche diélectrique $D_1$, ou reliant par des lignes $L_2$ conductrices des parties $P_1$ et $P'_1$ entre elles.

Les figures 6 montrent, vu du dessus, différents dispositifs obtenus par l'application du procédé selon l'invention.

La figure 6a montre l'interconnexion entre des lignes. Les parties $P_2$ sont représentés ici par les lignes 21 et 31 établies sur un premier niveau $N_1$ ainsi que par la ligne 41 également située sur ce premier niveau. La figure 6a est une représentation simpliée du dispositif, mais elle est cependant représentée à l'échelle d'un exemple d'application possible du procédé selon l'invention. La distance correspondant à 1 µm est représentée sur cette figure 6a. Dans cet exemple, on veut relier les lignes 21 et 31 par une ligne 25 formée à un niveau supérieur. Pour appliquer le procédé selon l'invention, du fait que les lignes 21, 31 et 41 ont des dimensions transversales à peu près équivalentes considérées comme $W_2$, on prévoit, lors de la formation des lignes 21 et 31, des appendices $P'_1$ 21' et 31' à l'extrémité de ces lignes que l'on désire connecter, ayant une dimension $W_1$ pour être assimilés à des parties $P_1$. Lors de la mise en oeuvre du procédé selon l'invention, des VIAS s'ouvrent automatiquement sur ces rétrécissements 21' et 31' et l'on peut alors réaliser la ligne $L_2$ 25 dans la couche métallique 15 de niveau supérieur avec un seul masque du fait que le masque d'ouverture de VIAS n'est pas nécessaire.

La figure 6b montre vu du dessus, schématiquement et non à l'échelle, une ligne 125 d'interconnexion $L_2$ de niveau supérieur réalisée au-dessus d'un VIA ouvert par le procédé selon l'invention sur la grille G formant une partie de type $P_1$ par exemple submicronique, de l'ordre de $W_1 = 0,25$ µm à 0,8 µm, d'un transistor à effet de champ, dans lequel S et D sont respectivement la source et le drain. Les électrodes S, G et D sont réalisées sur le premier niveau $N_1$, et S et D sont de dimensions $W_1$ beaucoup plus importantes que G, par exemple 5 à 8 µm formant les secondes parties $P_2$. Les électrodes S et D sont en outre espacées de G par une distance L de l'ordre de 1 à 2 µm, c'est-à-dire de l'ordre de 2 fois la dimension transversale $W_1$ de la grille G. Selon l'invention, la ligne $L_2$ d'interconnexion 125 peut être reliée à la grille G directement au-dessus du doigt de grille, sans qu'il soit nécessaire de prévoir à une extrémité de ce doigt, un plot de grande surface pour l'ouverture du VIA, comme cela est connu de l'état de la technique. Cette ligne d'interconnexion 125 peut aussi être placée à tout endroit de la grille G puisque toute la surface de cette dernière est ouverte par le procédé. Il en résulte une facilité de dessin pour le concepteur de circuit intégré. Selon l'invention, l'interconnexion se fait entre G et la ligne 125 avec un gain de place considérable. On peut ainsi relier plusieurs doigts de grille dans le cas de transistors interdigités.

Il est évident que le procédé selon l'invention peut être appliqué aussi pour connecter entre eux par exemple les émetteurs de transistors bipolaires non représentés. En effet, la surface supérieure de ces électrodes est légèrement plus élevée que la surface supérieure de la base et du collecteur de ce même transistor. De ce fait l'élévation $H_m$ de l'émetteur considéré comme première partie $P_1$ est supérieure à celle de la base et du collecteur considérés comme des troisième parties $P_3$. De plus, les dimensions de l'émetteur de l'ordre de 1 à 2 µm conviennent très bien pour appliquer l'invention, vu les dimensions de la base et du collecteur qui sont de l'ordre de 3 à 4 µm. Ici l'application de l'invention est particulièrement importante pour obtenir une épaisseur de diélectrique résiduel $H_R$ au-dessus de la base et du collecteur suffisant à leur isolement. Des ouvertures sur ces électrodes peuvent ensuite être réalisées par une méthode qui va être décrite plus loin.

En ce qui concerne un transistor planaire tel que celui de la figure 6b où les trois électrodes S, G et D ont à peu près la même hauteur $H_m$, mais n'ont pas toutes des dimensions appropriées à constituer des premières parties $P_1$, il suffit de prévoir, au niveau des autres électrodes S et D 122 et 121 respectivement, un appendice 122' et 121' de petite dimension $W_1$ sur lequel un VIA s'ouvrira automatiquement par la mise en oeuvre du procédé selon l'invention, incluant l'étape $E_2$ (voir figure 6b). Toutes les connexions peuvent alors être réalisées lors des mêmes étapes ($E_2$ + F), par exemple au moyen de la ligne $L_2$ 124 sur le tronçon 122' et au moyen de la ligne $L_2$ 123 sur le tronçon 121', les lignes 124 et 123 étant aussi constituées par exemple par la couche 15.

Les applications de l'invention dans le domaine des circuits intégrés sont donc nombreuses, du fait que l'on peut toujours prévoir un rétrécissement $P'_1$ d'une partie métallique du premier niveau $N_1$ sur le-

quel on désire ouvrir un VIA, dans le cas où cette partie ne présente pas les dimensions voulues pour entrer dans la catégorie des conditions imposées aux dimensions desdites premières parties $P_1$.

Le procédé selon l'invention peut aussi s'appliquer à la réalisation d'interconnexions entre des parties de motifs disposées au niveau dit premier niveau $N_1$ et d'autres parties disposées à un niveau inférieur, dit second niveau $N_2$, dans la réalisation des circuits intégrés, notamment les circuits microniques ou submicroniques, non planaires.

Les différents motifs sont métalliques ou semiconducteurs. Dans cet exemple, ils sont métalliques.

Tel que représenté sur la figure 5a, vu du dessus, et sur les figures 5b et 5c en coupe, ainsi que sur la figure 1a en coupe, sur le premier niveau $N_1$, on trouve lesdites premières parties $P_1$ présentant au moins une faible dimension $W_1$ mesurée parallèlement au niveau $N_1$, et lesdites secondes parties $P_2$ non représentées de dimensions plus élevées $W_2$. Sur le second niveau $N_2$ on trouve desdites troisièmes parties $P_3$ de dimensions quelconques.

L'objet du procédé est de réaliser des interconnexions entre les parties $P_3$ et $P_1$ d'un circuit non planaire, de protéger le circuit par une couche diélectrique de bonne qualité $D_1$, de réaliser des ouvertures en surface des premières parties $P_1$, de réaliser des lignes d'interconnexions $L_2$ ou autres motifs en surface de cette couche diélectrique $D_1$ pour relier entre elles des parties $P_1$ ou équivalentes à $P_1$. Cette couche diélectrique $D_1$ est de préférence à la fois planaire et non ouverte sur les motifs $P_2$ lors de l'opération des ouvertures sur les motifs $P_1$ qui a lieu sans utiliser de masques conventionnels difficiles à réaliser, à positionner et donc coûteux dans la mise en oeuvre d'un procédé.

Dans un exemple de mise en oeuvre, le procédé selon l'invention comporte d'abord l'étape A) déjà décrite précédemment. Mais dans cette étape, en même temps que l'on définit le dessin des parties $P_1$ et $P_2$, on définit des emplacements réservés ou régions d'interconnexions $R_3$ pour les motifs $P_3$ (voir les figures 5) et l'on réalise, sur le second niveau $N_2$ du circuit intégré, des parties $P_3$ de motifs métalliques ou semiconducteurs telles que représentés en coupe sur les figures 5b et 5c, ou vu du dessus sur la figure 5a, la figure 5c étant une coupe selon l'axe I-I de la figure 5a.

Ces parties $P_3$ sont non seulement réalisées sur un niveau inférieur $N_2$ du circuit, mais encore leur surface supérieure se place dans un plan inférieur à la surface supérieure des parties $P_1$, en sorte qu'une interconnexion planaire entre les parties $P_1$ et $P_3$ n'est pas possible.

Le premier niveau $N_1$ peut être la surface supérieure d'un empilement 11 de couches semiconductrices de différents matériaux ou de différents types de conductivité réalisées sur un substrat 10 d'un matériau semiconducteur tel que le silicium ou l'arséniure de gallium, ou un autre matériau du groupe III-V. Dans tout ce qui suit, ces supports seront désignés par S dans un but de simplification d'écriture.

Le niveau $N_2$ peut être constitué par une des différentes couches de l'empilement 11 qui constitue le niveau $N_1$. Les parties $P_3$ peuvent être réalisées par tout moyen connu de l'homme du métier. Par exemple le substrat 10 ou l'empilement 11 peut être gravé jusqu'au niveau $N_2$ dans l'ouverture d'un masque ou par auto-alignement sur d'autres motifs. Puis les parties $P_3$ sont réalisées sur le niveau $N_2$ au moyen de l'un des matériaux déjà cités pour la réalisation des parties $P_1$ et $P_2$.

Les dimensions des parties $P_3$ peuvent être quelconques. Les parties $P_3$ peuvent être par exemple des électrodes de collecteur ou de base de transistors bipolaires à hétérojonction (HBT), les parties $P_1$ étant alors soit des électrodes d'émetteurs de tels transistors, soit des lignes de connexion du premier niveau $N_1$. Les parties $P_3$ peuvent être aussi des grilles de transistors à effet de champ à grille enterrée.

Un problème se pose alors pour appliquer l'invention telle que décrite précédemment du fait de la différence de hauteur entre les surfaces supérieures des parties $P_3$ et des parties $P_1$, différence due en générale à la différence des niveaux $N_1$ et $N_2$.

C'est pourquoi, de préférence on intercale entre l'étape A décrite précédemment et l'étape B du procédé une étape :

A') formation éventuelle d'une marche ST entre la troisième parties $P_3$ et sa région d'interconnexion $R_3$ respective du premier niveau, ou sensiblement du premier niveau $N_1$ (voir la figure 5b).

La surface supérieure de la marche ST est à un niveau intermédiaire entre le niveau $N_1$ et le niveau $N_2$. On peut prévoir plus d'une marche si la différence de hauteur entre le niveau $N_1$ et le niveau $N_2$ est grande.

Si la partie $P_3$ à interconnecter est le collecteur d'un transistor HBT, le niveau supérieur de la marche ST peut être celui de la base du transistor, et la marche peut être formée par gravure conjointement à la formation de cette base (voir figure 5b).

Si la partie $P_3$ à interconnecter est la base d'un transistor HBT, le problème de la formation de la marche ST peut ne pas se poser (voir la figure 5c).

Que les marches (une ou plusieurs) ST s'avèrent nécessaires ou non, il peut être par ailleurs nécessaire pour préserver une région d'interconnexion $R_3$ au niveau $N_1$, ou sensiblement au niveau $N_1$, pour le motif $P_3$, de réaliser un plot 12 dont la surface supérieure est sensiblement au niveau $N_1$ (voir les figures 5b et 5c). Ce plot 12 est réalisé par toute méthode de gravure adaptée aux matériaux 10 ou 11.

Par ailleurs si la différence entre le niveau $N_1$ et le niveau $N_2$ est faible, une simple pente réalisée par gravure peut être suffisante pour permettre l'étape suivante qui s'intercale entre l'étape A' et l'étape B.

A") réalisation d'une dite première ligne conductrice $L_1$ reliant ladite troisième partie $P_1$ à sa région d'interconnexion $R_3$. Les marches ST sont prévues lorsque la dénivellation entre $N_1$ et $N_2$ est grande et risquerait de créer des failles dans la ligne $L_1$. C'est pourquoi l'homme du métier prévoit autant de marches que nécessaire. Cependant il est préférable pour ne pas allonger le procédé de prévoir la réalisation des marches conjointement à d'autres niveaux indispensables à la réalisation du circuit non planaire.

Lors de sa réalisation la première ligne conductrice $L_1$ est formée avec un dessin selon lequel, elle comprend dans la région d'interconnexion $R_3$, un rétrécissement ou un appendice $P''_1$ par exemple (voir les figures 5) présentant au moins une dimension transversale $W_1$ appropriée à permettre son classement dans la catégorie des premiers motifs $P_1$.

Cette ligne conductrice $L_1$, peut être en tout matériau habituellement utilisé en technologie des circuits intégrés pour réaliser les lignes d'interconnexion. Ce matériau peut être déposé dans l'ouverture d'un masque par une méthode usuelle connue de l'homme du métier.

A ce stade du procédé, on se reporte à l'étape B précédemment décrite. Cependant, chaque fois qu'il sera fait référence à une partie $P_1$, on comprendra également les parties $P'_1$ et $P''_1$ qui sont dotées des mêmes propriétés.

D'autre part, dans la suite du procédé, on préférera d'une façon générale, et plus spécialement dans le cas des circuits non planaires, la variante qui aboutit à la planarisation de la première couche diélectrique $D_1$ et donc du dispositif dans son ensemble.

Ainsi, selon le procédé, on peut réaliser grâce à la couche métallique supérieure 15 des interconnexions $L_2$ entre les parties $P_1$, ou $P'_1$ ou $P''_1$ dans des régions d'interconnexions choisies comme favorables, respectivement $R_1$, $R_2$, $R_3$. Et, comme la surface de la couche diélectrique restante $D_1$ peut être planaire, on peut former à sa surface outre la couche 15, toutes sortes d'autres motifs que des lignes d'interconnexion, de telle manière que le procédé selon l'invention peut être répété plusieurs fois.

**Revendications**

1. Procédé de réalisation d'un circuit semiconducteur intégré comprenant, pour réaliser des interconnexions (VIAS) entre un premier niveau et un second niveau de conducteurs de ce circuit, les étapes successives de :

    (a) formation, au premier niveau, sur un substrat S plan, de motifs conducteurs dits premier motifs présentant des premières parties $P_1$ et des secondes parties $P_2$ de hauteurs égales $H_m$, ayant au moins une de leurs di-

mensions, $W_1$ et $W_2$ respectivement, telle que la dimension $W_1$ dans les premières parties $P_1$ est très inférieure à la dimension $W_2$ dans les secondes parties $P_2$, tel que $W_1 \leqq W_2/2$ ;

    (b) croissance d'une première couche $D_1$ en un matériau d'isolation électrique, qui s'étend de façon uniforme sur le substrat muni des motifs avec la même épaisseur sur les premières et secondes parties $P_1$ et $P_2$, et entre ces parties ;

    (c) dépôt d'un seconde couche $D_2$ en un matériau diélectrique polymérisable, qui s'étend en présentant une épaisseur plus faible au-dessus des premières parties $P_1$ qu'au-dessus des secondes parties $P_2$, et polymérisation de cette couche ;

**caractérisé en ce que** dans l'étape b) l'épaisseur $H_d$ de la couche $D_1$ de matériau isolant au-dessus des premières et secondes parties de motifs $P_1$, $P_2$ est supérieure ou égale à la hauteur $H_m$ de ces parties $P_1$, $P_2$ de motifs, tel que $H_d \geqq H_m$, et en ce que ce procédé comprend ensuite les étapes successives de :

    (d) gravure de la seconde couche $D_2$ de matériau diélectrique, sans masque, de manière uniforme, avec arrêt de cette gravure dès que la première couche $D_1$ sous-jacente est découverte dans les régions où l'épaisseur de la seconde couche $D_2$ était plus faible, formant des ouvertures dans cette seconde couche $D_2$ exclusivement au-dessus des premières parties $P_1$,

    (e) gravure de la première couche $D_1$, à travers les ouvertures formées dans la seconde couche $D_2$, jusqu'à ce que les surfaces supérieures des premières parties $P_1$ soient découvertes, à l'exclusion des surfaces supérieures des secondes parties $P_2$, cette gravure étant pratiquée avec une vitesse d'attaque du matériau isolant de la première couche $D_1$ plus grande que la vitesse d'attaque du matériau de planarisation de la seconde couche $D_2$.

2. Procédé selon la revendication 1, caractérisé en ce que, dans l'étape a), des motifs conducteurs susceptibles d'être connectés avec des conducteurs du niveau supérieur du circuit sont munis de parties $P'_1$, éventuellement sous forme de rétrécissements ou d'appendices, ayant au moins une dimension $W_1$ et une hauteur $H_m$ répondant aux conditions imposées aux premières parties $P_1$.

3. Procédé selon l'une des revendications 1 ou 2, caractérisé en ce que dans l'étape a) des motifs conducteurs $P_3$ ayant une élévation inférieure à celle des premières parties $P_1$, et susceptibles d'être connectés à des conducteurs du niveau supérieur du circuit, sont munis de lignes conductrices $L_1$ présentant respectivement, d'une part des zones de contact avec ces troisièmes parties $P_3$, et d'autre part, des parties $P''_1$, éventuellement sous forme de rétrécissements ou appendices, ayant au moins une dimension $W_1$ et une élévation répondant aux conditions imposées aux premières parties $P_1$.

4. Procédé selon l'une des revendications 1 à 3, caractérisé en ce que l'épaisseur $H_d$ de la première couche diélectriques $D_1$ est choisie, en fonction de la hauteur $H_m$ des premières parties $P_1$ et de la différence $H_\ell$ entre l'épaisseur de la couche $D_2$ au-dessus des deuxièmes parties $P_2$ et l'épaisseur de la couche $D_2$ au-dessus des premières parties $P_1$, pour répondre à la condition :
$$H_d = H_m^2(H_m - H_\ell)^{-1}$$
et en ce que le rapport S de la vitesse de gravure de la première couche isolante $D_1$ sur la vitesse de gravure de la seconde couche planarisante $D_2$, dans l'étape de gravure e), est choisi pour répondre à la condition :
$$S = (H_d - H_m)H_\ell^{-1} > 1$$

5. Procédé selon l'une des revendications 1 à 4, caractérisé en ce qu'après la mise à découvert des premières parties $P_1$ et/ou les parties assimilables $P'_1$ et $P''_1$, il comprend les étapes successives de :

d) formation de motifs conducteurs dits seconds motifs du second niveau de conducteurs du circuit en surface de la couche isolante $D_1$, présentant des contacts avec les parties $P_1$, $P'_1$, $P''_1$, à travers les ouvertures pratiquées dans cette couche $D_1$ lors de l'étape e) pour l'interconnexion desdits premiers motifs du premier niveau de conducteurs avec lesdits seconds motifs du second niveau de conducteurs du circuit.

6. Procédé selon l'une des revendications 1 à 7, caractérisé en ce que le matériau isolant de la première couche $D_1$ est choisi parmi les matériaux qui croissent de manière uniforme, par exemple la silice (SiO2) ou le nitrure de silicium (Si3N4) et en ce que le matériau planarisant de la seconde couche $D_2$ est choisi parmi les matériaux qui se déposent sous forme fluide, par exemple le polyimide ou un photorésist.

7. Procédé selon l'une des revendications 5 ou 6, caractérisé en ce que les étapes définies précédemment sont répétées plusieurs fois, pour former plusieurs niveaux successifs de conducteurs, isolés par des couches de matériau $D_1$.

8. Procédé selon l'une des revendications précédentes, caractérisé en ce que les premières parties $P_1$ sont des motifs microniques ou submicroniques, par exemple des grilles de transistors à effet de champ ou des émetteurs de transistors bipolaires, en ce que les secondes parties $P_2$ sont des électrodes de composants actifs ou des lignes d'interconnexions, et en ce que les troisièmes parties $P_3$ sont des électrodes de composants actifs non planaires, par exemple des bases ou des collecteurs de transistors bipolaires.

## Patentansprüche

1. Verfahren zum Herstellen einer integrierten Halbleiterschaltung mit aufeinanderfolgenden Schritten zum Herstellen von Verbindungen (VIAS = Kontaktlöchern) zwischen einer ersten und einer zweiten Leiterbahnebene dieser Schaltung:

(a) Ausbildung von Leiterbahnstrukturen auf einer ersten Ebene auf einem flachen Substrat S, als erste Strukturen mit ersten Teilen $P_1$ und zweiten Teilen $P_2$ der Höhen $H_m$ bezeichnet, wobei mindestens eine ihrer Abmessungen $W_1$ bzw. $W_2$ so bemessen ist, daß die Abmessung $W_1$ in den ersten Teilen $P_1$ sehr viel geringer ist als die Abmessung $W_2$ in den zweiten Teilen $P_2$, zum Beispiel $W_1 \leqq W_2/2$;

(b) Aufwachsen einer ersten Schicht D1 aus einem elektrisch isolierenden Material, die sich gleichmäßig über das mit Strukturen gleicher Dicke in den ersten und zweiten Teilen $P_1$ und $P_2$ versehene Substrat und zwischen diesen Teilen erstreckt;

(c) Aufbringen einer zweiten Schicht $D_2$ aus einem polymerisierbaren dielektrischen Material, das sich in einer geringeren Dicke auf den ersten Teilen $P_1$ als auf den zweiten Teilen $P_2$ erstreckt, und Polymerisierung dieser Schicht;

dadurch gekennzeichnet, daß beim Schritt b) die Dicke $H_d$ der Schicht $D_1$ aus Isolierstoff über den ersten und zweiten Teilen der Strukturen $P_1$, $P_2$ größer oder gleich der Höhe $H_m$ dieser Teile $P_1$, $P_2$ der Strukturen, beispielsweise $H_d \geqq H_m$, ist, und daß dieses Verfahren danach folgende aufeinanderfolgende Schritte umfaßt:

(d) Gleichmäßiges Ätzen der zweiten Schicht $D_2$ aus dielektrischem Material ohne Maske, wobei dieses Ätzen gestoppt wird, sobald die darunterliegende erste Schicht $D_1$ in den Bereichen geringerer Dicke der zweiten Schicht $D_2$ freigelegt wird, mit Ausbildung von Öffnungen in dieser zweiten Schicht $D_2$ ausschließlich über den ersten Teilen $P_1$;

(e) Ätzen der ersten Schicht $D_1$ durch die in der zweiten Schicht $D_2$ ausgebildeten Öffnungen, bis die Oberseiten der ersten Teile $P_1$ freigelegt sind, unter Ausschluß der Obersei-

ten der zweiten Teile $P_2$, wobei dieses Ätzen mit einer höheren Ätzrate beim Isoliermaterial der ersten Schicht $D_1$ als beim Planarisierungsmaterial der zweiten Schicht $D_2$ erfolgt.

2. Verfahren nach Anspruch 1, dadurch gekennzeichnet, daß beim Schritt a) Leiterbahnstrukturen, die mit Leitern der oberen Ebene der Schaltung verbunden werden sollen, mit Teilen $P'_1$, eventuell in Form von Verschmälerungen oder Verlängerungen mit mindestens einem Maß $W_1$ und einer Höhe $H_m$ versehen sind, welche den für die ersten Teile $P_1$ vorgeschriebenen Bedingungen entsprechen.

3. Verfahren nach Anspruch 1 oder 2, dadurch gekennzeichnet, daß beim Schritt a) Leiterbahnstrukturen $P_3$ mit einer geringeren Erhebung wie bei denen der ersten Teile $P_1$, die mit Leitern der oberen Ebene der Schaltung verbunden werden sollen, mit Leiterbahnen $L_1$ versehen werden, die einerseits Kontaktflächen mit diesen dritten Teilen $P_3$ und andererseits Teile $P''_1$, eventuell in Form von Verschmälerungen oder Verlängerungen mit mindestens einem Maß $W_1$ und einer Erhebung versehen sind, welche den für die ersten Teile $P_1$ vorgeschriebenen Bedingungen entsprechen, darstellen.

4. Verfahren nach einem der Ansprüche 1 bis 3, dadurch gekennzeichnet, daß die Dicke $H_d$ der ersten dielektrischen Schicht $D_1$ in Abhängigkeit von der Höhe $H_m$ der ersten Teile $P_1$ und der Differenz $H_\ell$ zwischen der Dicke der Schicht $D_2$ über den zweiten Teilen $P_2$ und der Dicke der Schicht $D_2$ über den ersten Teilen $P_1$ so gewählt wird, daß sie folgende Bedingung erfüllt:
$$H_d = H_m^2 (H_m - H_\ell)^{-1}$$
und daß das Verhältnis $S$ der Ätzrate der ersten dielektrischen Schicht $D_1$ zur Ätzrate der zweiten dielektrischen Schicht $D_2$ beim zweiten Ätzschritt e) so gewählt wird, daß es folgende Bedingung erfüllt:
$$S = (H_d - H_m)H_\ell^{-1} > 1$$

5. Verfahren nach einem der Ansprüche 1 bis 4, dadurch gekennzeichnet, daß es nach dem Freilegen erster Teile $P_1$ und/oder der vergleichbaren Teile $P'_1$ und $P''_1$ aufeinanderfolgende Schritte umfaßt:

d) Ausbildung von zweiten Leiterbahnstrukturen der zweiten Ebene der Leiterbahnen der Schaltung an der Oberfläche der Isolierschicht $D_1$ mit Kontakten zu den Teilen $P_1$, $P'_1$, $P''_1$ durch die in dieser Schicht während des Schritts e) hergestellten Öffnungen zur Verbindung erster Strukturen der ersten Leiterbahnebene mit den zweiten Strukturen der zweiten Leiterbahnebene der Schaltung.

6. Verfahren nach einem der Ansprüche 1 bis 5, dadurch gekennzeichnet, daß daer Isolierstoff der ersten Schicht $D_1$ aus den Materialien gewählt wird, die gleichmäßig aufwachsen, beispielsweise Silizium ($SiO_2$) oder Siliziumnitrid ($Si_3N_4$), und daß das planarisierende Material der zweiten Schicht $D_2$ aus den Materialien gewählt wird, die naß aufgetragen werden, beispielsweise Polyimid oder ein Fotoresist.

7. Verfahren nach einem der Ansprüche 5 oder 6, dadurch gekennzeichnet, daß die zuvor definierten Schritte mehrmals wiederholt werden, um mehrere aufeinanderfolgende Leiterbahnebenen auszubilden, die durch Schichten aus dem Material $D_1$ voneinander getrennt werden.

8. Verfahren nach einem der vorhergehenden Ansprüche, dadurch gekennzeichnet, daß die ersten Teile $P_1$ Strukturen im Mikrometer- oder Submikrometerbereich sind, beispielsweise Gates von Feldeffekttransistoren oder Emitter von Bipolartransistoren, daß die zweiten Teile $P_2$ Elektroden aktiver Bauelemente oder Verbindungsleitungen sind, und daß die dritten Teile $P_3$ Elektroden nichtplanarer aktiver Bauelemente, beispielsweise Basis oder Kollektor von Bipolartransistoren, sind.

## Claims

1. A method of manufacturing an integrated semiconductor circuit comprising the following steps for the realisation of interconnections (vias) between a first level and a second level of conductors of said circuit:

   (a) the formation at a first level on a plane substrate S of first conducting patterns having first parts $P_1$ and second parts $P_2$ of equal height $H_m$, of which at least one of their dimensions $W_1$ and $W_2$, respectively, such as the dimension $W_1$ in the first parts $P_1$, is substantially smaller than the dimension $W_2$ in the second parts $P_2$ such that
   $$W_1 \leqq W_2/2;$$
   (b) the growth of a first layer $D_1$ of an electrically insulating material which extends uniformly over the substrate provided with the patterns with the same thickness on the first and second parts $P_1$ and $P_2$ and between these parts:

   (c) the deposition of a second layer $D_2$ of a polymerizable dielectric material which extends over the first parts $P_1$ with a smaller thickness than over the second parts $P_2$, and

polymerization of this layer;
characterized in that in step b) the thickness $H_d$ of the layer $D_1$ of insulating material above the first and second parts $P_1$, $P_2$ of the patterns is greater than or equal to the height $H_m$ of said parts $P_1$, $P_2$ of the patterns such that $H_d \geqq H_m$, and in that the method subsequently comprises the successive steps:

(d) uniform etching of the second layer $D_2$ of dielectric material without mask, which etching is stopped the moment the subjacent first layer $D_1$ is uncovered in the regions where the thickness of the second layer $D_2$ was smaller, forming openings in said second layer $D_2$ exclusively above the first parts $P_1$,

(e) etching of the first layer $D_1$ through the openings formed in the second layer $D_2$ until the upper surfaces of the first parts $P_1$ are uncovered, to the exclusion of the upper surfaces of the second parts $P_2$, which etching is carried out with an attacking rate on the insulating material of the first layer $D_1$ which is greater than the attacking rate on the planarizing material of the second layer $D_2$.

2. A method as claimed in Claim 1, characterized in that in step a) conducting patterns which are to be connected to conductors of the upper level of the circuit are provided with parts $P'_1$, possibly in the form of narrowed or appended parts, which have at least a dimension $W_1$ and a height $H_m$ which satisfy the conditions imposed on the first parts $P_1$.

3. A method as claimed in Claim 1 or 2, characterized in that in step a) conducting patterns $P_3$ which have an elevation lower than that of the first parts $P_1$ and which are to be connected to conductors at the upper level of the circuit are provided with conducting lines $L_1$ which exhibit on the one hand contact zones with said third parts $P_3$ and on the other hand parts $P''_1$, possibly in the form of narrowed or appended parts, which have at least a dimension $W_1$ and a height which satisfy the conditions imposed on the first parts $P_1$.

4. A method as claimed in any one of Claims 1 to 3, characterized in that the thickness $H_d$ of the first dielectric layer $D_1$ is chosen as a function of the height $H_m$ of the first parts $P_1$ and of the difference $H_\ell$ between the thickness of the layer $D_2$ above the second parts $P_2$ and the thickness of the layer $D_2$ above the first parts $P_1$ so as to satisfy the condition:

$$H_d = H_m^2 (H_m - H_\ell)^{-1},$$

and in that the ratio S of the rate of etching of the first dielectric layer $D_1$ to the rate of etching of the second dielectric layer $D_2$ in the second etching step e) is chosen so as to satisfy the condition:

$$S = (H_d - H_m)H_\ell^{-1} > 1.$$

5. A method as claimed in any one of the Claims 1 to 4, characterized in that after uncovering of the surface of the first parts $P_1$ and/or of the assimilable parts $P'_1$ and $P''_1$, it comprises the following successive steps:

d/ the formation of so-called second conducting patterns at the second level of conductors of the circuit on the surface of the insulating layer $D_1$, comprising contacts with the parts $P_1$, $P'_1$, $P''_1$ through the openings provided in this layer $D_1$ during step e) for the interconnection of said first patterns of the first level of conductors with said second patterns of the second level of conductors of the circuit.

6. A method as claimed in any one of the Claims 1 to 5, characterized in that the insulating material of the first layer $D_1$ is chosen from among the materials which exhibit a uniform growth, for example silica ($SiO_2$) or silicon nitride ($Si_3N_4$), and in that the planarizing material of the second layer $D_2$ is chosen from among the materials which are deposited in a fluid form, for example polyimide or a photoresist.

7. A method as claimed in one of Claims 5 and 6, characterized in that the steps defined above are repeated several times for forming several successive conductor levels, insulated by layers of the material $D_1$.

8. A method as claimed in any one of the preceding Claims, characterized in that the first parts $P_1$ are micron or submicron patterns, for example gates of field effect transistors or emitters of bipolar transistors, in that the second parts $P_2$ are electrodes of active elements or interconnection lines, and in that the third parts $P_3$ are electrodes of active non-planar elements, for example bases or collectors of bipolar transistors.

FIG.1a

FIG.1b

FIG.1c

FIG.1d

FIG.2a

FIG.2b

FIG.3a

FIG.3b

FIG.4a

FIG.4b

FIG.4c

FIG.5a

FIG.5b

FIG.5c

1µm

41(P₂)

21(P₂)  21'(P'₁)  25(L₂)  31'(P'₁)  31(P₂)

W₂  W₁  W₁  W₂

W₂

## FIG.6a

124(L₂)  123(L₂)

122'(P'₁)  (P'₁)121'

W₁  W₁  125(L₂)

122  121

S(P₂)  W₁  G(P₁)  D(P₂)

W₂  W₂

## FIG.6b